# EUROPEAN PATENT SPECIFICATION

(11) **EP 4 521 508 B1**
(45) Date of publication and mention of the grant of the patent: **14.01.2026**
(21) Application number: 23195565.9
(22) Date of filing: 05.09.2023
(51) Int. Cl.: H01M 10/42, H01M 10/48, H01M 50/242

(54) **BATTERY SYSTEM AND METHOD FOR MONITORING A BATTERY SYSTEM**
BATTERIESYSTEM UND VERFAHREN ZUR ÜBERWACHUNG EINES BATTERIESYSTEMS
SYSTÈME DE BATTERIE ET PROCÉDÉ DE SURVEILLANCE D'UN SYSTÈME DE BATTERIE

(43) Date of publication of application: 12.03.2025
(73) Proprietor: Samsung SDI Co., Ltd., Yongin-si, Gyeonggi-do 17084 (KR)
(72) Inventor: Ipek, Eymen, 8020 Graz (AT)
(74) Representative: Gulde & Partner

(56) References cited:
- EP-A1- 3 392 070
- CN-A- 114 977 367
- DE-A1- 102019 207 435
- DE-A1- 102021 101 500
- US-A1- 2023 032 112

## Description

### Field of the Disclosure

The present disclosure relates to a battery system, an underbody deformation detection system for the battery system and a method for monitoring the battery system.

### Technological Background

Recently, vehicles for transportation of goods and peoples have been developed that use electric power as a source for motion. Such an electric vehicle is an automobile that is propelled permanently or temporarily by an electric motor, using energy stored in rechargeable batteries. An electric vehicle may be solely powered by batteries (Battery Electric Vehicle, BEV) or may include a combination of an electric motor and, for example, a conventional combustion engine (Plugin Hybrid Electric Vehicle, PHEV). BEVs and PHEVs use high-capacity rechargeable batteries, which are designed to give power for propulsion over sustained periods of time.

A battery cell includes an electrode assembly including a positive electrode, a negative electrode, and a separator interposed between the electrodes. A solid or liquid electrolyte allows movement of ions during charging and discharging of the battery cell. The electrode assembly is located in a casing and electrode terminals, which are positioned on the outside of the casing, establish an electrically conductive connection to the electrodes. The shape of the casing may be, for example, cylindrical or rectangular.

A battery module is formed of a plurality of battery cells connected in series or in parallel. That is, the battery module may be formed by interconnecting the electrode terminals of the plurality of battery cells in an arrangement or configuration depending on a desired amount of power and in order to realize a high-power rechargeable battery.

Battery modules can be constructed in either a block design or in a modular design. In the block design each battery cell is coupled to a common current collector structure and a common battery management system and the unit thereof is arranged in a housing. In the modular design, pluralities of battery cells are connected together to form submodules and several submodules are connected together to form the battery module. In automotive applications, battery systems often generally include a plurality of battery modules connected in series for providing a desired voltage.

A battery pack is a set of any number of (for example identical) battery modules or single battery cells. The battery modules, respectively battery cells, may be configured in a series, parallel or a mixture of both to deliver the desired voltage, capacity, and/or power density. Components of a battery pack include the individual battery modules, and the interconnects, which provide electrical conductivity between the battery modules.

Battery systems according to the related art, despite any modular structure, usually includes a battery housing that acts as enclosure to seal the battery system against the environment and provides structural protection for the battery system components. Housed battery systems are usually mounted as a whole into their application environment, such as an electric vehicle. Thus, the replacement of defective system parts, for example a defect battery submodule, requires dismounting the whole battery system and removal of its housing first. Even defects of small and/or cheap system parts might then require dismounting and replacement of the complete battery system and its separate repair. As high-capacity battery systems are expensive, large, and heavy, this procedure is burdensome and the storage, for example in the mechanic's workshop, of the bulky battery systems becomes difficult.

A thermal system to provide thermal control of the battery pack is often included to safely use the at least one battery module by efficiently emitting, discharging and/or dissipating heat generated from its rechargeable batteries. If the heat emission, discharge, and/or dissipation is not sufficiently performed, temperature deviations may occur between respective battery cells, such that the battery module may no longer generate a desired (or designed) amount of power. In addition, an increase of the internal temperature can lead to abnormal reactions occurring therein, and thus, charging and discharging performance of the rechargeable deteriorates and the life-span of the rechargeable battery is shortened. Thus, cell cooling for effectively emitting, discharging, and/or dissipating heat from the cells is important.

It is common that a battery pack has a cooler on the bottom side of the battery pack to cool the battery cells. Typically, an underbody structure is in place and used to protect the battery cell against an underbody contact events. If the electric vehicle drives over loose ground and stones are thrown up or a foreign object touches the ground plate of the electric vehicle, this might create an underground contact event. The underbody structure is designed in a way that the force will be distributed into cross beams of the underbody structure. The battery cells should not be affected by such an underbody contact event.

To avoid severe damage to the battery pack or the cooling system for the battery pack due to an underbody contact event, underbody contact detection systems are known from related art that can detect an underbody contact event and evaluate the dangerousness of such an underbody contact event.

In this respect, an underbody contact detection system for an electrical vehicle is known from DE 10 2019 207 435 A1, wherein an underbody protection system is arranged above the terrain driven on at the underbody of the vehicle. The underbody protection system consists of at least three layers, namely an outer layer adjacent to the terrain driven on, one inner layer adjacent to the inside of the vehicle and an intermediate layer which produces a defined distance between the outer layer and the inner layer. According to the concept as described in DE 10 2019 207 435 A1, the layers are designed in such a way that when a defined force is exerted on the outer layer from the terrain driven on, the intermediate layer and/or the outer layer and the intermediate layer are deformed by reducing the distance between the outer layer and inner layer. The layers are directly or indirectly arranged elements of an electrical circuit or act on parts of an electrical circuit. Approaching of the outer layer and the inner layer causes a detectable change in the electrical properties of the electrical circuit.

US2023 / 032 112 A1 disclose systems and methods for determining a deformation event in a battery pack. The battery pack may comprise a conductive path coupled to a first electrical connector and a second electrical connector. Processing circuitry may be configured to detect a change in an electrical characteristic of the conductive path indicating a transition from a first circuit state of the conductive path to a second circuit state of the conductive path. The processing circuitry may be configured to determine, in response to the detecting, a deformation event in the battery pack.

From DE 102021 101 500 A1 a method for detecting intrusion of a traction battery, an underbody element and a motor vehicle with such an underbody element is known. The underbody element for the motor vehicle comprises at least one sensor device which has at least one electrically conductive sensor wire which is integrated into a flat textile material, the sensor device being designed to measure a voltage applied to the sensor wire and to determine a deformation of the sensor wire as a function of a measured change in the voltage.

EP 3 392 070 A1 discloses a battery pack, comprising a plurality of battery cells arranged in a battery housing, wherein the battery housing has at least one electrically insulating protective plate, at least one deformation sensor which comprises an electrically conductive coating which is applied to the protective plate, and at least one evaluation circuit for detecting a change in resistance of the at least one deformation sensor. A plurality of deformation sensors is provided, and the deformation sensors are arranged in separate segments of the protective plate. EP 3 392 070 A1 further discloses an electric vehicle comprising at least one such battery pack.

Furthermore, CN 114 977 367 A discloses an energy storage system, comprising at least one storage device for storing electrical energy, a base body for receiving the at least one storage device, at least one deformation element, at least one contact element and a detection device for detecting a deformation of the deformation element, the at least one deformation element and the at least one contact element are arranged together at least in regions on the outer side of the base body, the detection device is connected to the at least one deformation element and/or the at least one contact element in an electrically conductive manner and is designed to detect a degree of deformation of the at least one deformation element, the degree of deformation of the at least one deformation element can be detected by detecting an electrical resistance by a detection device when the at least one deformation element and the at least one contact element are in contact.

### Summary of Invention

The invention is defined by the appended claims. The description that follows is subjected to this limitation. Any disclosure lying outside the scope of said claims is only intended for illustrative as well as comparative purposes.

According to one aspect of the present disclosure, there is provided a battery system, including:
a battery pack including a housing and a plurality of battery cells accommodated within the housing;
an underbody deformation detection system, wherein the underbody deformation detection system includes a first conductor arranged in an upper plane and a second conductor arranged in a lower plane, wherein the first conductor and the second conductor at least partially overlap in a top view, wherein the underbody deformation detection system is adapted to monitor at least one electrical measurand between the first conductor and the second conductor and to determine a deformation of the lower plane of the underbody deformation detection system.

According to another aspect of the present disclosure, the invention is directed to an electric vehicle including a battery system as described in the previous paragraph.

Yet another aspect of the present disclosure refers to a method for monitoring a battery system, where the method includes the steps of
a) providing a battery system as described in the previous paragraphs,
b) continuously measuring at least one electric measurand between the first conductor and the second conductor,
c) detecting an underbody contact or impact event, when a change in the one electrical measurand exceeds a certain threshold value.

Further aspects of the present disclosure could be learned from the dependent claims or the following description.

### Brief Description of the Drawings

Features will become apparent to those of ordinary skill in the art by describing in detail exemplary embodiments with reference to the attached drawings in which:
- Fig. 1: illustrates a schematic view of an electric vehicle with a battery system including an underbody deformation detection system according to an embodiment of the invention.
- Fig. 2: illustrates a schematic perspective view of the underbody deformation detection system according to an embodiment of the invention without an underbody contact event.
- Fig. 3: illustrates a schematic cross section of the underbody deformation detection system in case of an underbody impact.
- Fig. 4: schematically illustrates an electrical circuit of an underbody deformation detection system according to an embodiment of the present invention.
- Fig. 5: schematically illustrates the electric circuit of Fig. 4 in case of an underbody impact event.
- Figs. 6A and 6B: illustrate another embodiment of an underbody deformation detection system according to the present invention.
- Fig. 7: illustrates an electric circuit of yet another embodiment of the underbody deformation detection system according to the present invention.
- Fig. 8: illustrates the electric circuit of Fig. 7 in case of an underbody impact event.
- Fig. 9: schematically illustrates the resistors of the electric circuit of Fig. 7 which affect the total resistance.
- Fig. 10: schematically illustrates the resistors of the electric circuit of Fig. 7 which affect the total resistance in case of underbody impact event.
- Fig. 11: illustrates a flow chart of a method for monitoring a battery system according to another aspect of the invention.

### Detailed Description of the Invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art.

Accordingly, processes, elements, and techniques that are not considered necessary to those having ordinary skill in the art for a complete understanding of the aspects and features of the present disclosure may not be described. In the drawings, the relative sizes of elements, layers, and regions may be exaggerated for clarity.

As used herein, the term "and/or" includes any and all combinations of one or more of the associated listed items. Further, the use of "may" when describing embodiments of the present disclosure refers to "one or more embodiments of the present disclosure." In the following description of embodiments of the present disclosure, the terms of a singular form may include plural forms unless the context clearly indicates otherwise.

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present disclosure. As used herein, the term "and/or" includes any and all combinations of one or more of the associated listed items. Expressions such as "at least one of," when preceding a list of elements, modify the entire list of elements and do not modify the individual elements of the list.

It will be further understood that the terms "include," "comprise," "including," or "comprising" specify a property, a region, a fixed number, a step, a process, an element, a component, and a combination thereof but do not exclude other properties, regions, fixed numbers, steps, processes, elements, components, and combinations thereof.

Herein, the terms "upper" and "lower" are defined according to the z-axis. For example, the upper cover is positioned at the upper part of the z-axis, whereas the lower cover is positioned at the lower part thereof. In the drawings, the sizes of elements may be exaggerated for clarity. For example, in the drawings, the size or thickness of each element may be arbitrarily shown for illustrative purposes, and thus the embodiments of the present disclosure should not be construed as being limited thereto.

In the following description of embodiments of the present disclosure, the terms of a singular form may include plural forms unless the context clearly indicates otherwise.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

### General Concept

According to one aspect of the present disclosure, the invention is directed to a battery system, including a battery pack including a housing and a plurality of battery cells accommodated within the housing. The battery system further includes an underbody deformation detection system, wherein the underbody deformation detection system includes a first conductor arranged in an upper plane and a second conductor arranged in a lower plane. The first conductor and the second conductor at least partially overlap in a top view. The underbody deformation detection system is adapted to monitor at least one electrical measurand between the first conductor and the second conductor and to determine a deformation of the lower plane of the underbody deformation detection system.

In other words, there is provided a battery system for an electrical vehicle, including a battery pack with a plurality of battery cells arranged in a housing and forming the battery pack. The battery system further includes a detection system adapted to detect underbody contact or impact events, wherein the detection system includes a first conductor and a second conductor which are each arranged in parallel planes to each other and are spaced apart by a gap. The first conductor and the second conductor overlap in a top view, such that an underbody contact or impact event leads to an approach of the second conductor towards the first conductor. The detection system is adapted to monitor at least one electrical measurand that characterizes the gap between the first conductor and the second conductor and therefore allows to determine a deformation of the lower plane of the underbody deformation detection system.

The battery system according to the invention allows to detect underbody contact or impact events and rate the potential damage to the battery system caused by the underbody contact or impact event. In other words, the battery system allows to detect blows and impacts on the underbody structure, and to evaluate the severity of these blows and impacts.

According to an embodiment of the invention, the electrical measurand is a conductivity between the first conductor and the second conductor. The conductivity is the measurand to detect the distance between the first conductor and the second conductor and to assess, whether a contact event between the first conductor and the second conductor has happened. This allows to detect underbody contact or impact events and rate the severity of those events.

Alternatively, the capacitance, the charge and/or the field strength between the first conductor and the second conductor can be evaluated to detect and rate an underbody contact event.

In an advantageous embodiment of the invention, it is provided that the underbody deformation detection system includes at least one flexible printed circuit board which forms one of the conductors. In other words, the underbody deformation detection system may comprise a flexible printed circuit board including the first conductor and/or a flexible printed circuit board including the second conductor. This allows a simple and inexpensive formation of the electrical conductor to monitor the distance from the upper plane and the lower plane of the underbody deformation detection system.

Alternatively or additionally, it is provided that the underbody deformation detection system includes a flexible flat cable and printed circuit boards attached to the flexible flat cable to form the first conductor and/or second conductor. Building the conductors out of flexible flat cables and printed circuit boards is another simple and inexpensive way for forming the electrical conductor to monitor the distance from the upper plane and the lower plane of the underbody deformation.

According to another embodiment of the battery system, it is provided that the underbody deformation detection system is adapted to monitor the conductivity by determining a resistance and/or a current flow between the first conductor and the second conductor. In case the gap between the first conductor and the second conductor changes, in particular closes, there will be changes in the resistance and/or a current flow between the first conductor and the second conductor. In case of a contact event between the first conductor and the second conductor there might be changes in the electric circles of the first conductor and the second conductor such as short circuits or closed electrical connections, that effect the resistance and/or the current flow, such that a contact event can be detected. A comparatively light impact leads to an elastic deformation of the conductor, whereby a short-term change in voltage or current can be detected. A violent impact can lead to a plastic deformation of the conductor, so that a permanent change in the voltage and/or the current intensity is measured. This allows not only to detect underbody contact or impact events, but also assess the severity of such underbody contact or impact events.

According to the invention, it is provided that the underbody deformation detection system includes electrically conductive pads electrically connected to the first conductor or the second conductor. Electrically conductive pads are a simple an inexpensive way for monitoring a wider area of the underbody system. The arrangement of several electrical pads distributed over the underbody makes it possible not only to detect the occurrence of a contact event, but also to localize the place of impact. Therefore, it is possible to assess, whether a critical area of the battery system such as a cooling pipe or an electrical connector have been hit by the underbody contact or impact event.

According to the invention, it is provided that the upper plane includes a first set of electrically conductive pads electrically connected to the first conductor and the lower plane includes a second set of electrically conductive pads electrically connected to the second conductor. This makes it easy to create a net with which the upper plane and the lower plane can be evenly covered in order to detect potential underbody contact events.

For example, the electrically conductive pads are arranged such that each of the electrically conductive pads in the upper plane overlaps and faces an electrically conductive pad in the lower plane in the top view. In such an arrangement, contact of the lower plate with the upper plate causes a circuit to be closed or shortened. This is immediately reflected in a change of the electrical resistance, the electrical field and/or a change of the measured electrical voltage, whereby the location of a contact of the first conductor with the second conductor can be detected.

According to another embodiment of the invention, all electrically conductive pads within one conductor are the same. The use of the same electrically conductive pads allows to reduce the number of variants. This allows economies of scale to be achieved, reducing component prices. Furthermore, this eliminates a source of danger in assembly, since it is not possible to mix up different electrically conductive pads.

In another embodiment of the invention, it is provided that all electrically conductive pads are arranged equally distanced from each other within one plane. In this way, a particularly uniform mesh can be formed, in which a particularly uniform coverage of the entire area of the underbody deformation detection system can be achieved.

According to yet another embodiment of the invention, the first conductor includes a plurality of first conductor elements which are arranged in parallel, and the second conductor includes a plurality of second conductor elements which are arranged in parallel, wherein the first conductor elements and the second conductor elements cross each other. The cross-shaped arrangement leads to the fact that the meshes of the network are closed and thus the corresponding branches of the power network are shortened. The closing of the meshes leads to a change in the electrical resistance as well as the electrical field, which can be evaluated accordingly to detect an underbody contact.

According to an embodiment of the battery system, the underbody deformation detection system includes an underbody protection plate arranges below the lower plane. Such an underbody protection plate, which is arranged between the lower plane and a road surface of a road or path traveled by the electric motor vehicle, protects the battery system from impacts and shocks to the vehicle underbody. Such a protective plate can in particular form a vehicle underbody of the electric vehicle and be designed in terms of thickness and shape in such a way that frequently occurring underbody contacts, for example caused by churned-up grit and small stones, are reliably kept away from the battery system without causing damage to the battery system.

According to another aspect of the invention, it is provided an electric vehicle including a battery system as described in the preceding sections. While underbody contact or impact events are also critical to vehicles with internal combustion engines, where an underbody impact can damage a fuel tank arranged in the vehicles underground, it is particularly critical to electric vehicles, where a large battery pack is arranged near the underground in order to achieve a low center of gravity for the vehicle to improve driving performance and to protect the battery pack as good as possible from damage in the event of an accident of the electric vehicle.

Yet another aspect of the invention is related to a method for monitoring a battery system, wherein the method includes the steps of:
a) providing a battery system as described in the preceding sections,
b) continuously measuring at least one electrical measurand between the first conductor and the second conductor, that is related to a distance of the first conductor and the second conductor,
c) detecting an underbody contact or impact event, when a change in the one electrical measurand exceeds a certain threshold value.

The method allows to detect underbody contact or impact events and to rate the severity of such events in order to protect the battery pack from a damage caused by the underbody contact or impact event.

In an embodiment of the invention, it is provided that a critical underbody contact event is detected, when the second conductor has a plastic deformation such that the second conductor permanently contacts the first conductor. A plastic deformation is related to a sever impact on the underbody protection plate, such as there is a plastic deformation. If such a plastic deformation of the lower plane is detected, there should be a security check of the battery system in a workshop.

### Specific Embodiments

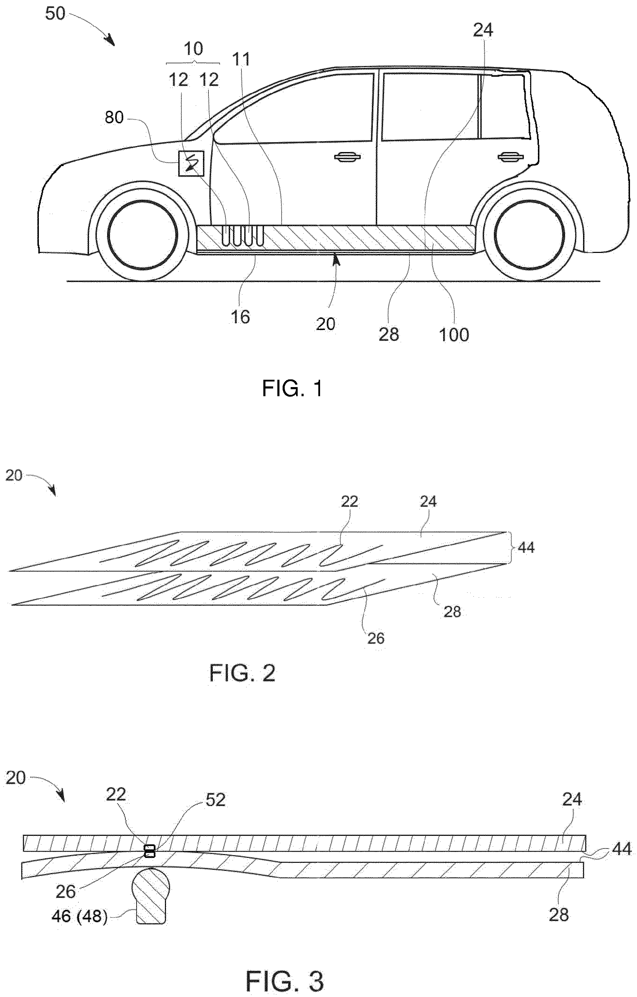

Fig. 1 is a schematic view illustrating an electric vehicle 50 with an electric engine 80 and a battery system 100 including an underbody deformation detection system 20 according to an embodiment of the invention. Fig. 2 is an enlarged and schematic view on the underbody deformation detection system 20 of Fig. 1 in an undamaged initial state.

The battery system 100 of the electric vehicle 50 includes a battery pack 10, which in turn contains a plurality of battery cells 12. The battery pack 10 is accommodated within a housing 11 of the battery system 100. As can be seen from Fig. 1, the battery system 100 is mounted in a underbody of the electric vehicle 50. The underbody deformation detection system 20 is located underneath the housing 11 at the bottom of the electric vehicle 50.

The underbody deformation detection system 20 includes an assembly of an upper plane 24 and a lower plane 28 as schematically illustrated in Fig. 2. Below the underbody deformation detection system 20, an underbody protection plate 16 is mounted which closes the assembly to the underbody of the electric vehicle 50. In the assembly, the upper plane 24 is located directly below the housing 11, while the lower plane 28 is adjacent to the underbody protection plate 16. A first conductor 22 is arranged in the upper plane 24 and a second conductor 26 is arranged in the lower plane 28 of the underbody deformation detection system 20. The first conductor 22 and the second conductor 26 overlap at least partially in a top view. The upper plane 24 and the lower plane 28 are spaced apart such that a gap 44 is formed between the first conductor 22 and second conductor 26. The underbody deformation detection system 20 is adapted to monitor at least one electric measurand that characterizes the gap 44 between the first conductor 22 and the second conductor 26 and whose change indicates a deformation of the lower plane 28. In this way, the underbody deformation detection system 20 can monitor a deformation of the lower plane 28.

Fig. 3 shows the underbody deformation detection system 20 after an underbody impact event caused by a bollard 46 or obstacle 48. As you can see in Fig. 3, the lower plane 28 is deformed such that the gap 44 between the upper plane 24 and the lower plane 28 is closed and the second conductor 26 in the lower plane 28 contacts the first conductor 22 in the upper plane 24 at a connection point 52. The connection point 52 closes an electrical circuit such that an electrical measurand changes and an underbody impact event can be detected.

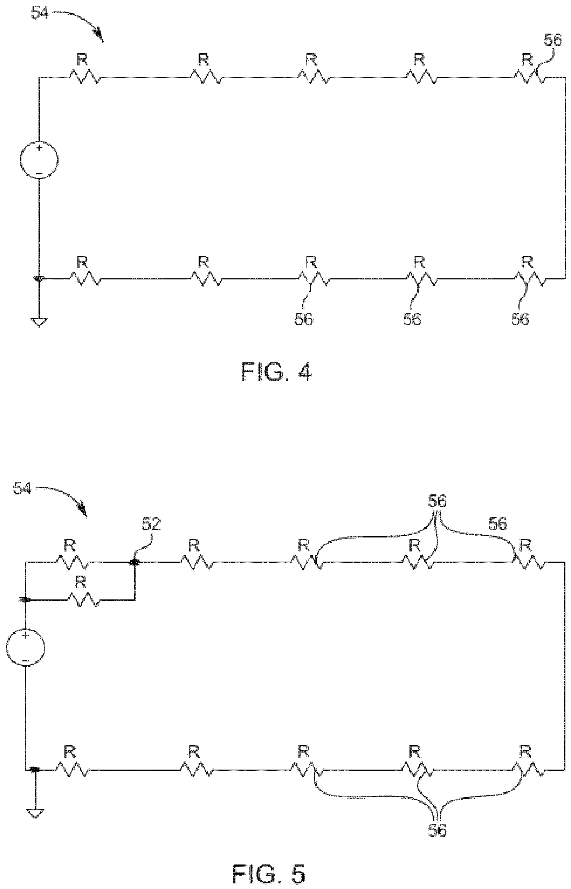

Fig. 4 shows an embodiment of an electrical circuit 54 of the underbody deformation detection system 20 in an undamaged initial state. The electrical circuit 54 includes a plurality of electrical resistors 56 connected in series. As shown in Fig. 5, an underbody impact event that leads to a deformation of the lower plane 28 and therefore to the connection point 52 between the first conductor 22 and the second conductor 26 changes the voltage difference in the electrical circuit 54. In this case, the lower plane 28 contacts the upper plane 24 on the upper left corner. By the change in voltage, an underbody impact event can be detected and measures to increase battery safety such as an improved cooling and a warning to have the battery system 100 checked in a workshop can be transmitted to the driver.

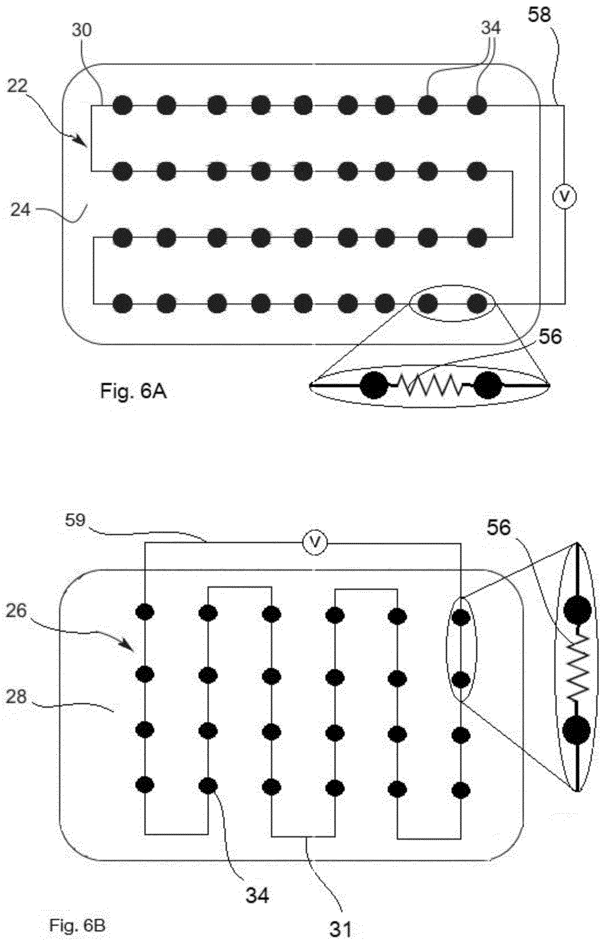

Fig. 6A and 6B illustrate modifications of an upper plane 24, respectively a lower plane 28 of an underbody deformation detection system 20 according to another embodiment of the present invention. The upper plane 24 includes a first conduct 22 and lower plane 28 includes a second conductor 26 as the upper plane and the lower plane of the above embodiment.

According to the embodiment, the upper plane 24 is formed of a flexible carrier material. The first conductor 22 includes a first electrically conductive path 30 and a plurality of conductive pads 34 which are arranged on the first electrically conductive path 30 with a predetermined spacing. Resistors 56 are located between each of the conductive pads 34 as shown by way of example in the enlarged section on the right below in Fig. 6A. Resistors 56 and conductive pads 34 are serially connected to a first signal conditioning circuit 58. The upper plane 24, the first electrically conductive path 30, the conductive pads 34, and the resistors 56 may be realized as a flexible printed circuit board, FPC board.

The lower plane 28 has a similar structure to the upper plane 24 and is also formed of a flexible carrier material. The second conductor 26 includes a second electrically conductive path 31 and a plurality of conductive pads 34 which are arranged on the second electrically conductive path 31 with a predetermined spacing. Resistors 56 are located between each of the conductive pads 34 as shown by way of example in the enlarged section on the right in Fig. 6B. Resistors 56 and conductive pads 34 are serially connected to a second signal conditioning circuit 59. The lower plane 28, the second electrically conductive path 31, the conductive pads 34, and the resistors 56 may be realized as a flexible printed circuit board, FPC board.

When the battery system 100 is installed, the upper plane 24 and the lower plane 28 are distanced from each other by a certain gap, similar to the embodiment shown in Fig. 2. The conductive pads 34 arranged in the upper plane 24 and the conductive pads 34 arranged in the lower plane 28 overlap and face each other in the top view. In case of an underbody impact event, the plane surfaces of the upper plane 24 and the lower plane 28 may contact each other thereby creating a different resistance chain than in an undamaged initial state.

The first signal conditioning circuit 58 and the second signal conditioning circuit 59 are configured for monitoring a resistance of the first electrically conductive path 30, respectively the second electrically conductive path 31. The recorded signals are transmitted to the battery management system, BMS (not shown). The signals are evaluated in the BMS, the BMS is used to monitor whether a significant change in the detected resistance occurs. Accordingly, an evaluation algorithm stored in the BMS is part of the underbody deformation detection system 20. Alternatively, the underbody deformation detection system 20 may include its own evaluation unit. In case a significant change in resistance occurs, potential damage to the underbody of the vehicle, respectively damage to housing 11 of the battery system 100 can be assumed. The BMS may then issue an appropriate warning signal requesting that the potential damage be checked.

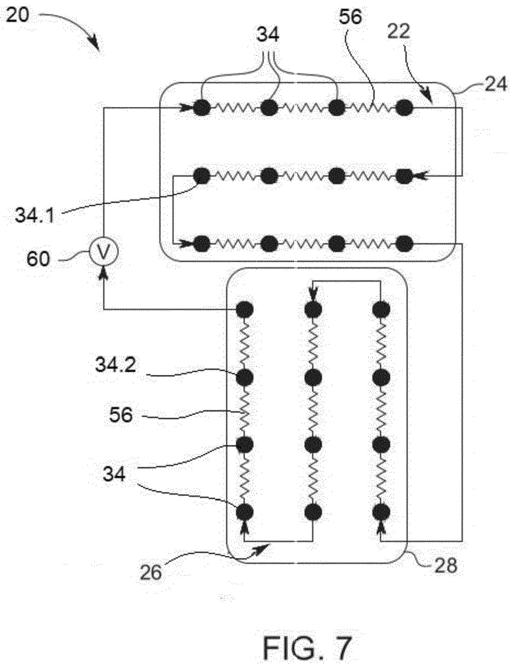

Figs. 7 to 10 illustrate electric circuits of an underbody deformation detection system 20 according to yet another embodiment of the present invention. The underbody deformation detection system 20 also include an upper plane 24 having a first conductor 22 and a lower plane 28 having a second conductor 26 as the above embodiments.

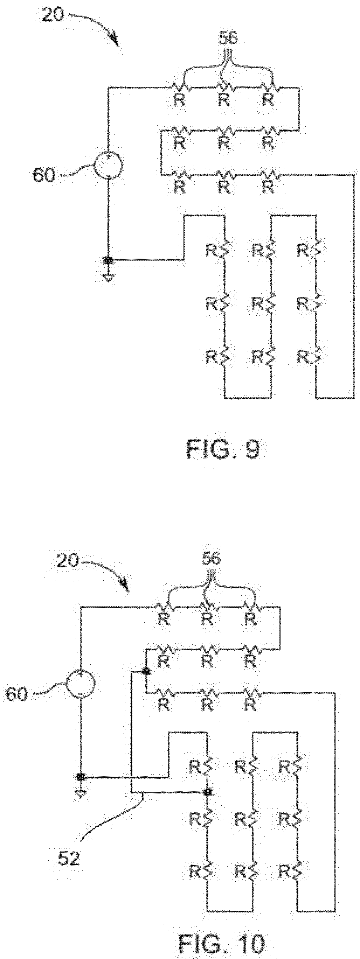

In Fig. 7, the underbody deformation detection system 20 is in an undamaged initial state. The first conductor 22 arranged in the upper plane 24 and the second conductor 26 arranged in the lower plane 28 are connected in series. The first conductor 22 and the second conductor 26 include a plurality of conducting pads 34, respectively. A number of resistors 56 are located between the conducting pads 34. Further, a signal conditioning circuit 60 monitors a resistance of the electric circuit. The upper plane 24 and the lower plane 28 are aligned in such a manner that there is a gap between them and conducting pads 34 are facing each other. For example, a conducting pad 34.1 of the first conductor 22 faces a conducting pad 34.2 of the second conductor 26 and there is a predetermined gap between them. For simplification, Fig. 9 illustrates only the resistors 56 of first conductor 22 and the second conductor 26. The number of eighteen resistors 56 add up to an overall resistance of the electric circuit which is measured by the signal conditioning circuit 60.

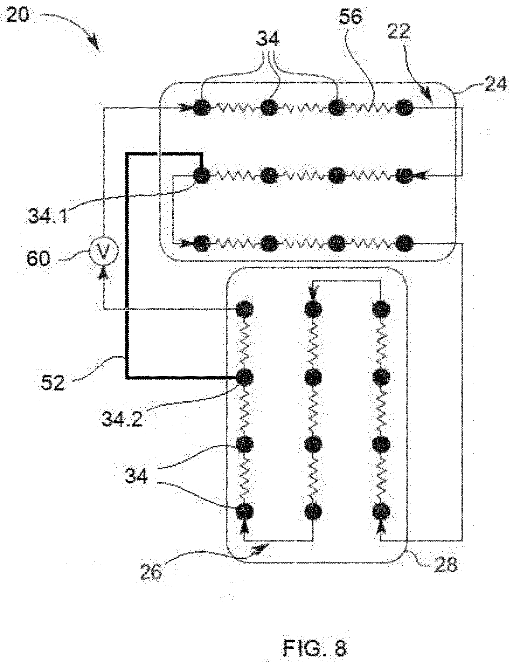

Fig. 8 schematically illustrates the same underbody deformation detection system 20 after an underbody impact event. Purely by way of example, the impact has led to the situation that the conducting pad 34.2 of the second conductor 26 is pushed towards the conducting pad 34.1 of the first conductor 22 and closes the gap therebetween. In Fig. 8, a connection point 52 between the conducting pads 34.1 and 34.2 is schematically illustrated by a line. Due to the contact, the overall resistance of the electric circuit changes and the change can be monitored by the signal conditioning circuit 60.

For simplification, Fig. 10 schematically illustrates only the resistors 56 of the electric circuit of Fig. 8 which affect the total resistance in case of underbody impact event. Due to connection point 52, the total resistance results from only seven resistors 56. Accordingly, a significant change of the overall resistance can be monitored by the signal conditioning circuit 60 indicating a deformation of the underbody.

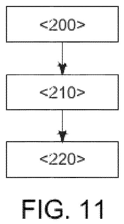

Fig. 11 shows a flow chart for a method for monitoring a battery system 100 according to the invention, wherein in a first step <200> of the method, a battery system 100 as described in the preceding paragraphs is provided. In a step <210>, an electrical measurand, e.g., a voltage, a current or an electrical conductivity between the first conductor 22 and the second conductor 26 is measured continuously. In a step <220>, a sever underbody contact event or an underbody impact event is detected, when a change in the electrical measurand exceeds a certain threshold value, for example when the lower plane 28 is permanently deformed such that the second conductor 26 contacts the first conductor 22 at a connection point 52 permanently.

### Reference signs

- 10: battery pack
- 11: housing
- 12: battery cell
- 16: underbody protection plate
- 20: underbody deformation detection system
- 22: first conductor
- 24: upper plane
- 26: second conductor
- 28: lower plane
- 30: first electrically conductive path
- 31: second electrically conductive path
- 34: conductive pad
- 34.1: conductive pad of the first conductor 22
- 34.2: conductive pad of the second conductor 26
- 44: gap
- 46: bollard
- 48: obstacle
- 50: electric vehicle
- 52: connection point
- 56: resistor
- 58: first signal conditioning circuit
- 59: second signal conditioning circuit
- 80: electric engine
- 100: battery system

## Claims

1. A battery system (100), comprising:
a battery pack (10) comprising a housing (11) and a plurality of battery cells (12) accommodated within the housing (11); and
an underbody deformation detection system (20), wherein the underbody deformation detection system (20) comprises a first conductor (22) arranged in an upper plane (24) and a second conductor (26) arranged in a lower plane (28), wherein the first conductor (22) and the second conductor (26) at least partially overlap in a top view, wherein the underbody deformation detection system (20) is adapted to monitor at least one electrical measurand between the first conductor (22) and the second conductor (26) and to determine a deformation of the lower plane (28) of the underbody deformation detection system (20), wherein the upper plane (24) comprises a first set of electrically conductive pads (34) electrically connected to the first conductor (22) and the lower plane (28) comprises a second set of electrically conductive pads (34) electrically connected to the second conductor (26).

2. The battery system (100) according to claim 1, wherein the electrical measurand is a conductivity between the first conductor (22) and the second conductor (26).

3. The battery system (100) according to any one of the preceding claims, wherein the underbody deformation detection system (20) comprises a flexible printed circuit board comprising the first conductor (22) and/or a flexible printed circuit board comprising the second conductor (26).

4. The battery system (100) according to any one of the preceding claims, wherein the underbody deformation detection system (20) comprises a flexible flat cable and a plurality of printed circuit boards attached to the flexible flat cable to form the first conductor (22) and/or second conductor (26).

5. The battery system (100) according to claim 2, wherein the underbody deformation detection system (20) is adapted to monitor the conductivity by determining a resistance and/or a current flow between the first conductor (22) and the second conductor (26).

6. The battery system (100) according to any of the preceding claims, wherein the electrically conductive pads (34) are arranged such that each of the electrically conductive pads (34) in the upper plane (24) overlaps and faces an electrically conductive pad (34) in the lower plane (28) in the top view.

7. The battery system (100) according to any one of the preceding claims, wherein the electrically conductive pads (34) within one conductor (22, 26) are the same.

8. The battery system (100) according to any one of the preceding claims, wherein the electrically conductive pads (34) are arranged equally distanced from each other within one plane (24, 28).

9. The battery system (100) according to any one of the preceding claims, wherein the first conductor (22) comprises a plurality of first conductor elements which are arranged in parallel and the second conductor (26) comprises a plurality of second conductor elements which are arranged in parallel, wherein the first conductor elements and the second conductor elements cross each other.

10. The battery system (100) according to any one of the preceding claims, wherein the underbody deformation detection system (20) comprises an underbody protection plate (16) arrange below the lower plane (28).

11. An electric vehicle (50) comprising the battery system (100) according to any one of the preceding claims.

12. A method for monitoring a battery system (100), wherein the method comprises the steps of:
a) providing a battery system (100) as defined in claim 1;
b) continuously measuring at least one electrical measurand between the first conductor (22) and the second conductor (26);
c) detecting an underbody contact or impact event, when a change in the one electrical measurand exceeds a certain threshold value.

13. The method according to claim 12, wherein a critical underbody contact event is detected when the second conductor (26) has a plastic deformation such that the second conductor (26) contacts the first conductor (22) permanently.

## Patentansprüche

1. Batteriesystem (100), umfassend:
einen Batteriepack (10) mit einem Gehäuse (11) und mehreren Batteriezellen (12), die innerhalb des Gehäuses (11) untergebracht sind; und
ein Unterbodenverformungserkennungssystem (20), wobei das Unterbodenverformungserkennungssystem (20) einen ersten Leiter (22), der in einer oberen Ebene (24) angeordnet ist, und einen zweiten Leiter (26), der in einer unteren Ebene (28) angeordnet ist, umfasst, wobei sich der erste Leiter (22) und der zweite Leiter (26) in einer Draufsicht zumindest teilweise überlappen, wobei das Unterbodenverformungserkennungssystem (20) dazu ausgelegt ist, mindestens eine elektrische Messgröße zwischen dem ersten Leiter (22) und dem zweiten Leiter (26) zu überwachen und eine Verformung der unteren Ebene (28) des Unterbodenverformungserkennungssystems (20) zu bestimmen, wobei die obere Ebene (24) einen ersten Satz elektrisch leitender Pads (34) umfasst, die elektrisch mit dem ersten Leiter (22) verbunden sind, während die untere Ebene (28) einen zweiten Satz elektrisch leitender Pads (34) umfasst, die elektrisch mit dem zweiten Leiter (26) verbunden sind.

2. Batteriesystem (100) nach Anspruch 1, wobei die elektrische Messgröße eine Leitfähigkeit zwischen dem ersten Leiter (22) und dem zweiten Leiter (26) ist.

3. Batteriesystem (100) nach einem der vorstehenden Ansprüche, wobei das Unterbodenverformungserkennungssystem (20) eine flexible Leiterplatte mit dem ersten Leiter (22) und/oder eine flexible Leiterplatte mit dem zweiten Leiter (26) umfasst.

4. Batteriesystem (100) nach einem der vorstehenden Ansprüche, wobei das Unterbodenverformungserkennungssystem (20) ein flexibles Flachkabel und mehrere Leiterplatten umfasst, die an dem flexiblen Flachkabel angebracht sind, um den ersten Leiter (22) und/oder den zweiten Leiter (26) zu bilden.

5. Batteriesystem (100) nach Anspruch 2, wobei das Unterbodenverformungserkennungssystem (20) dazu ausgelegt ist, die Leitfähigkeit durch Bestimmen eines Widerstands und/oder eines Stromflusses zwischen dem ersten Leiter (22) und dem zweiten Leiter (26) zu überwachen.

6. Batteriesystem (100) nach einem der vorstehenden Ansprüche, wobei die elektrisch leitenden Pads (34) so angeordnet sind, dass jedes der elektrisch leitenden Pads (34) in der oberen Ebene (24) in der Draufsicht ein elektrisch leitendes Pad (34) in der unteren Ebene (28) überlappt und diesem gegenüberliegt.

7. Batteriesystem (100) nach einem der vorstehenden Ansprüche, wobei die elektrisch leitenden Pads (34) innerhalb eines Leiters (22, 26) identisch sind.

8. Batteriesystem (100) nach einem der vorstehenden Ansprüche, wobei die elektrisch leitenden Pads (34) in gleichem Abstand voneinander innerhalb einer Ebene (24, 28) angeordnet sind.

9. Batteriesystem (100) nach einem der vorstehenden Ansprüche, wobei der erste Leiter (22) mehrere erste Leiterelemente umfasst, die parallel angeordnet sind, während der zweite Leiter (26) mehrere zweite Leiterelemente umfasst, die parallel angeordnet sind, wobei sich die ersten Leiterelemente und die zweiten Leiterelemente kreuzen.

10. Batteriesystem (100) nach einem der vorstehenden Ansprüche, wobei das Unterbodenverformungserkennungssystem (20) eine Unterbodenschutzplatte (16) umfasst, die unterhalb der unteren Ebene (28) angeordnet ist.

11. Elektrofahrzeug (50) mit dem Batteriesystem (100) nach einem der vorstehenden Ansprüche.

12. Verfahren zum Überwachen eines Batteriesystems (100), wobei das Verfahren die folgenden Schritte umfasst:
a) Bereitstellen eines Batteriesystems (100) nach Anspruch 1;
b) kontinuierliches Messen mindestens einer elektrischen Messgröße zwischen dem ersten Leiter (22) und dem zweiten Leiter (26);
c) Erfassen eines Unterbodenkontakts oder eines Aufprallereignisses, wenn eine Änderung der einen elektrischen Messgröße einen bestimmten Schwellenwert überschreitet.

13. Verfahren nach Anspruch 12, wobei ein kritisches Unterbodenkontakt-Ereignis erfasst wird, wenn der zweite Leiter (26) eine plastische Verformung aufweist, so dass der zweite Leiter (26) dauerhaft mit dem ersten Leiter (22) in Kontakt steht.

## Revendications

1. Système de batterie (100), comportant :
un bloc-batterie (10) comportant un boîtier (11) et une pluralité d'éléments de batterie (12) reçus au sein du boîtier (11) ; et
un système de détection de déformation de soubassement (20), dans lequel le système de détection de déformation de soubassement (20) comporte un premier conducteur (22) agencé dans un plan supérieur (24) et un second conducteur (26) agencé dans un plan inférieur (28), dans lequel le premier conducteur (22) et le second conducteur (26) se chevauchent au moins partiellement dans une vue de dessus, dans lequel le système de détection de déformation de soubassement (20) est conçu pour surveiller au moins un grandeur de mesure électrique entre le premier conducteur (22) et le second conducteur (26) et pour déterminer une déformation du plan inférieur (28) du système de détection de déformation de soubassement (20), dans lequel le plan supérieur (24) comporte un premier ensemble de plots électriquement conducteurs (34) électriquement connectés au premier conducteur (22) et le plan inférieur (28) comporte un second ensemble de plots électriquement conducteurs (34) électriquement connectés au second conducteur (26).

2. Système de batterie (100) selon la revendication 1, dans lequel la grandeur de mesure électrique est une conductivité entre le premier conducteur (22) et le second conducteur (26).

3. Système de batterie (100) selon l'une quelconque des revendications précédentes, dans lequel le système de détection de déformation de soubassement (20) comporte une carte de circuit imprimé souple comportant le premier conducteur (22) et/ou une carte de circuit imprimé souple comportant le second conducteur (26).

4. Système de batterie (100) selon l'une quelconque des revendications précédentes, dans lequel le système de détection de déformation de soubassement (20) comporte un câble plat souple et une pluralité de cartes de circuit imprimé fixées au câble plat souple pour former le premier conducteur (22) et/ou le second conducteur (26).

5. Système de batterie (100) selon la revendication 2, dans lequel le système de détection de déformation de soubassement (20) est conçu pour surveiller la conductivité par la détermination d'une résistance et/ou d'un flux de courant entre le premier conducteur (22) et le second conducteur (26).

6. Système de batterie (100) selon l'une quelconque des revendications précédentes, dans lequel les plots électriquement conducteurs (34) sont agencés de sorte que chacun des plots électriquement conducteurs (34) dans le plan supérieur (24) chevauche et soit en face d'un plot électriquement conducteur (34) dans le plan inférieur (28) dans la vue de dessus.

7. Système de batterie (100) selon l'une quelconque des revendications précédentes, dans lequel les plots électriquement conducteurs (34) au sein d'un conducteur (22, 26) sont identiques.

8. Système de batterie (100) selon l'une quelconque des revendications précédentes, dans lequel les plots électriquement conducteurs (34) sont agencés à égale distance les uns des autres au sein d'un plan (24, 28).

9. Système de batterie (100) selon l'une quelconque des revendications précédentes, dans lequel le premier conducteur (22) comporte une pluralité d'éléments de premier conducteur qui sont agencés en parallèle et le second conducteur (26) comporte une pluralité d'éléments de second conducteur qui sont agencés en parallèle, dans lequel les éléments de premier conducteur et les éléments de second conducteur se croisent mutuellement.

10. Système de batterie (100) selon l'une quelconque des revendications précédentes, dans lequel le système de détection de déformation de soubassement (20) comporte une plaque de protection de soubassement (16) agencée au-dessous du plan inférieur (28).

11. Véhicule électrique (50) comportant le système de batterie (100) selon l'une quelconque des revendications précédentes.

12. Procédé de surveillance d'un système de batterie (100), dans lequel le procédé comporte les étapes suivantes :
a) la fourniture d'un système de batterie (100) selon la revendication 1 ;
b) la mesure en continu d'au moins une grandeur de mesure électrique entre le premier conducteur (22) et le second conducteur (26) ;
c) la détection d'un événement de contact ou d'impact avec le soubassement, lorsqu'un changement de l'une grandeur de mesure électrique dépasse une certaine valeur seuil.

13. Procédé selon la revendication 12, dans lequel un événement critique de contact avec le soubassement est détecté lorsque le second conducteur (26) présente une déformation plastique telle que le second conducteur (26) est en contact avec le premier conducteur (22) de façon permanente.
